# EUROPEAN PATENT SPECIFICATION

(11) **EP 4 163 963 B1**
(45) Date of publication and mention of the grant of the patent: **25.09.2024**
(21) Application number: 21834681.5
(22) Date of filing: 30.06.2021
(51) Int. Cl.: H01L 23/427, H01L 23/373, H01L 23/367

(54) **HEAT CONDUCTION MEMBER, SINGLE BOARD, COMPUTING DEVICE AND MANUFACTURING METHOD**
WÄRMELEITELEMENT, EINZELPLATINE, COMPUTERVORRICHTUNG UND HERSTELLUNGSVERFAHREN
ÉLÉMENT CONDUCTEUR THERMIQUE, CARTE INDIVIDUELLE, DISPOSITIF INFORMATIQUE ET PROCÉDÉ DE FABRICATION

(30) Priority: 03.07.2020 CN 202010631523; 31.07.2020 CN 202010761273
(43) Date of publication of application: 12.04.2023
(73) Proprietor: Huawei Technologies Co., Ltd., Longgang District, Shenzhen, Guangdong 518129 (CN)
(72) Inventor: LIU, Xiaorui, Shenzhen, Guangdong 518129 (CN); CHU, Sheng, Guangzhou, Guangdong 510275 (CN); DENG, Chaojun, Shenzhen, Guangdong 518129 (CN); YANG, Yong, Shenzhen, Guangdong 518129 (CN); TANG, Xiaoyu, Shenzhen, Guangdong 518129 (CN); WANG, Bo, Shenzhen, Guangdong 518129 (CN); WANG, Cong, Shenzhen, Guangdong 518129 (CN)
(74) Representative: Körber, Martin Hans
(86) International application number: PCT/CN2021/103853
(87) International publication number: WO 2022/002170

(56) References cited:
- CN-A- 1 801 482
- CN-A- 103 725 261
- CN-A- 103 725 261
- CN-A- 109 003 953
- CN-A- 109 003 953
- CN-U- 209 845 582
- US-A1- 2007 091 574
- US-A1- 2009 122 491
- US-A1- 2011 240 279
- US-A1- 2011 240 279

## Description

### TECHNICAL FIELD

This application relates to the field of chip technologies, and in particular, to a heat conduction component, a board, a computing device, and a manufacturing method.

### BACKGROUND

A chip of a computing device generates much heat during operation. To dissipate heat for the chip of the computing device, a heat sink is usually mounted on the chip, and the chip dissipates the heat outward via the heat sink.

Generally, a heat conduction component is placed between the heat sink and the chip, so that the heat on the chip can be transferred to the heat sink via the heat conduction component, and the heat sink dissipates the heat outward.

However, how to accelerate heat transfer between the chip, the heat conduction component, and the heat sink is still a problem that needs to be urgently resolved currently.
CN109003953A discloses a heat dissipation fin, comprising a heat conducting metal fin and a first liquid metal layer and a second liquid metal layer respectively arranged on two sides of the heat conducting metal fin.
CN103725261A discloses a ternary liquid metal heat interface material with dual melting points. The liquid metal heat interface material adopts a three-layered foil-shaped structure, wherein the upper layer and the lower layer are made of 56% indium, 20% of bismuth and 24% of tin by mole; the middle layer is made of 40% of indium, 48% of bismuth and 12% of tin by mole. A hole between a heating element and a radiator can be completely filled with the liquid metal heat interface material at a relatively low temperature after initial mounting, and then the liquid metal heat interface material is solidified due to diffusion. The liquid metal heat interface material is solid at normal working temperatures. When the temperature of an electronic device is raised to a design value, the liquid metal heat interface material can be melted twice to cool the electronic device sharply.
US2011240279A1 discloses hybrid liquid metal-solder thermal interface, which a thermal interface for coupling a heat generating device to a heat sink includes a first metal interface layer, a second metal interface layer, and an isolation layer positioned between the first metal interface layer and the second metal interface layer. At least one of the first metal interface layer and the second metal interface layer comprises a liquid metal.

### SUMMARY

Embodiments of this application provide a heat conduction component, a board, a computing device, and a manufacturing method, to overcome a problem in a related technology. The technical solutions are as follows.

According to an aspect, a heat conduction component is provided. The heat conduction component includes a first heat conduction layer and second heat conduction layers. A melting point of the first heat conduction layer is greater than a first value, a melting point of the second heat conduction layer is less than a second value, there is the second heat conduction layer on each of a first surface and a second surface of the first heat conduction layer, and the first surface and the second surface are opposite to each other.

The melting point of the first heat conduction layer is higher than the melting point of the second heat conduction layer, and the first value is greater than the second value. For example, the first value may be 130 degrees Celsius, and the second value may be within 100 degrees Celsius. The specific melting point of the first heat conduction layer and the specific melting point of the second heat conduction layer are both related to an operation temperature of a heat source component. For example, the melting point of the first heat conduction layer is at least higher than a maximum temperature that the heat source component can reach during operation. The specific melting point of the second heat conduction layer is lower than the maximum temperature that the heat source component can reach during operation, and is close to a temperature of the heat source component during normal operation. For example, the specific melting point of the second heat conduction layer is close to an average temperature of the heat source component during operation.

In an example, the heat conduction component includes the first heat conduction layer and the second heat conduction layers. There may be one first heat conduction layer and two second heat conduction layers, and the first heat conduction layer is sandwiched between the two second heat conduction layers, to form a heat conduction component of a sandwich structure. In an embodiment, the heat conduction component has a three-layer structure, an intermediate layer is the first heat conduction layer, and there is the second heat conduction layer on each of the first surface and the second surface of the first heat conduction layer

In this way, when the heat conduction component is filled between the heat source component and a heat sink, the heat source component is tightly attached to a second heat conduction layer of the heat conduction component, and the heat sink is tightly attached to another second heat conduction layer of the heat conduction component.

In order to improve tight attachment between the heat source component and the second heat conduction layer and tight attachment between the heat sink and the second heat conduction layer, the melting point of the second heat conduction layer is low. For example, the melting point of the second heat conduction layer is lower than the second value. In this way, when the heat conduction component is filled between the heat source component and the heat sink, the heat source component generates a large amount of heat during operation, and the second heat conduction layer that is of the heat conduction component and that is in contact with the heat source component may partially melt to generate liquid A surface area of the liquid is large, so that the liquid can be flatly spread on a surface that is of the heat source component and that is in contact with the second heat conduction layer. Even if there is an original gap between the heat source component and the second heat conduction layer of the heat conduction component, after the second heat conduction layer partially melts, the generated liquid can also fill the gap, to improve the tight attachment between the heat source component and the second heat conduction layer and accelerate heat transfer.

Similarly, the second heat conduction layer that is of the heat conduction component and that is in contact with the heat sink may also partially melt to generate liquid. A surface area of the liquid is large, so that the liquid can be flatly spread on a surface that is of the heat sink and that is in contact with the second heat conduction layer. Even if there is an original gap between the heat sink and the second heat conduction layer of the heat conduction component, after the second heat conduction layer partially melts, the generated liquid can also fill the gap, to improve the tight attachment between the heat sink and the second heat conduction layer and accelerate heat transfer

In a possible implementation, there may be both a plurality of the first heat conduction layers and a plurality of the second heat conduction layers, and the plurality of the first heat conduction layers and the plurality of the second heat conduction layers are stacked and fixed to obtain the heat conduction component, where there is the second heat conduction layer on each of a first surface and a second surface of each first heat conduction layer

Because there is the second heat conduction layer on each of the first surface and the second surface of each first heat conduction layer, a quantity of the second heat conduction layers is greater than that of the first heat conduction layers. For example, there may be two first heat conduction layers, and there may be three second heat conduction layers, the first heat conduction layers and the second heat conduction layers are alternately stacked, and there is the second heat conduction layer on each of the first surface and the second surface that are of each first heat conduction layer and that are opposite to each other, to form a heat conduction component of a five-layer structure. One surface of the outermost two surfaces of the heat conduction component is used for tightly attaching to the heat source component, and the other surface is used for tightly attaching to the heat sink.

In a possible implementation, one first heat conduction layer and a plurality of the second heat conduction layers are included. Alternatively, in another embodiment, a plurality of the first heat conduction layers and second heat conduction layers are included.

A person skilled in the art may flexibly select quantities of the first heat conduction layers and the second heat conduction layers based on an actual requirement. A specific quantity of the first heat conduction layers and a specific quantity of the second heat conduction layers are not limited in embodiments.

In a possible implementation, the first heat conduction layer and the second heat conduction layer are compatible, so that when the second heat conduction layer melts into liquid, the liquid can be infiltrated into the first heat conduction layer.

In an example, to prevent damage to the heat source component caused by the liquid flowing into the heat source component after the second heat conduction layer melts into the liquid, accordingly, the first heat conduction layer may be a solid heat conduction layer with a high melting point. For example, the melting point of the first heat conduction layer is higher than the first value. In addition, a material for forming the first heat conduction layer and a material for forming the second heat conduction layer are similar in structure, to implement compatibility between the first heat conduction layer and the second heat conduction layer. In this way, when the second heat conduction layer melts and is converted into the liquid, the liquid may be infiltrated into the first heat conduction layer, so as to prevent the liquid of the second heat conduction layer from flowing into the heat source component or the heat sink.

Based on the foregoing descriptions, in the heat conduction component filled between the heat source component and the heat sink, a second heat conduction layer is tightly attached to the heat source component, and another second heat conduction layer is tightly attached to the heat sink. In this way, heat is generated by the heat source component during operation, and the second heat conduction layer in contact with the heat source component partially melts to generate the liquid Surface tension of the liquid is large, so that the liquid can be tightly attached to the surface of the heat source component. In this way, the gap between the heat conduction component and the heat source component is eliminated, and a heat transfer effect between the heat source component and the heat sink is enhanced.

The second heat conduction layer in contact with the heat sink may also partially melt to generate the liquid Surface tension of the liquid is large, so that the liquid can be tightly attached to the surface of the heat sink. In this way, the gap between the heat conduction component and the heat sink is eliminated, and the heat transfer effect between the heat source component and the heat sink is enhanced.

In addition, because phase transition from solid to liquid occurs on the second heat conduction layer tightly attached to the heat source component, and a large amount of heat is absorbed in a phase transition process, heat is dissipated for the heat source component.

In this invention, there are protrusion structures on each of a first surface and a second surface of the second heat conduction layer, and the first surface and the second surface of the second heat conduction layer are opposite to each other.

In an example, the protrusion structure may also be referred to as an undulated structure. The protrusion structure may be a columnar protrusion, for example, a cylindrical protrusion. The protrusion structure may alternatively be a strip-shaped protrusion. For example, there are periodically arranged strip-shaped protrusion structures on each of the first surface and the second surface of the second heat conduction layer. The protrusion structure may alternatively be a sawtooth-shaped structure. For example, there are sawtooth-shaped structures on each of the first surface and the second surface of the second heat conduction layer.

The protrusion structures on the first surface and the second surface of the second heat conduction layer are submillimeter-level or micrometer-level structures, and may be used to absorb mounting tolerances and mounting gaps, so as to improve tight attachment of the surfaces.

In an example, there are protrusion structures on the first surface and the second surface of the second heat conduction layer, and the undulated protrusion structures are fine, soft, and elastic. When the heat conduction component is filled between the heat source component and the heat sink, the protrusion structures on the two surfaces of the second heat conduction layer can be compressed and deformed under pressure, to ensure that all parts of the second heat conduction layer are in a compressed state. Therefore, tight attachment between the first heat conduction layer and the second heat conduction layers, tight attachment between the heat source component and the second heat conduction layer of the heat conduction component, and tight attachment between the heat sink and the another second heat conduction layer of the heat conduction component can be improved.

Once the tight attachment between the first heat conduction layer and the second heat conduction layers inside the heat conduction component, the tight attachment between the heat source component and the heat conduction component, and the tight attachment between the heat sink and the heat conduction component are improved, heat in the heat source component can be quickly transferred to the heat sink via the heat conduction component, and the heat sink dissipates the heat outward to accelerate heat dissipation for the heat source component.

In a possible implementation, there are protrusion structures on each of the first surface and the second surface of the first heat conduction layer.

In an example, there are the protrusion structures on each of the two surfaces that are of the first heat conduction layer and that are opposite to each other, and the undulated protrusion structures are small, soft, and elastic. When the first heat conduction layer is sandwiched between two second heat conduction layers, both the protrusion structures on the first heat conduction layer and protrusion structures on the second heat conduction layers can be compressed and deformed under pressure. In this way, the tight attachment between the first heat conduction layer and the second heat conduction layers is improved, seamless contact inside the heat conduction component is implemented, and quick transfer of heat inside the heat conduction component is accelerated.

In a possible implementation, the protrusion structure is any one of a columnar protrusion, a strip-shaped protrusion, and a sawtooth-shaped protrusion.

In some examples, the protrusion structure may also be referred to as an undulated structure. The protrusion structure may be a columnar protrusion, for example, a cylindrical protrusion. The protrusion structure may alternatively be a strip-shaped protrusion. For example, there are periodically arranged strip-shaped protrusion structures on each of the first surface and the second surface of the second heat conduction layer. The protrusion structure may alternatively be a sawtooth-shaped protrusion. For example, there are sawtooth-shaped protrusions on each of the first surface and the second surface of the second heat conduction layer.

In a possible implementation, both the first heat conduction layer and the second heat conduction layer are metal layers.

In an example, a metal generally has high thermal conductivity. To accelerate heat transfer of the heat conduction component, the corresponding first heat conduction layer and the corresponding second heat conduction layer may both be metal layers, and have high thermal conductivity.

In a possible implementation, the first heat conduction layer is a metal indium layer, and the second heat conduction layer is an indium bismuth tin alloy layer.

In an example, the first heat conduction layer may be a metal indium layer, and the second heat conduction layer may be an indium bismuth tin alloy layer. A melting point of the metal indium layer is about 157 degrees Celsius, and an operating temperature of the heat source component generally does not exceed 100 degrees Celsius. Therefore, the metal indium layer can meet requirements on both high thermal conductivity and a high melting point, and can be used as the first heat conduction layer of the heat conduction component. A melting point of the indium bismuth tin alloy layer is between 58 degrees Celsius and 60 degrees Celsius, and heat generated by the heat source component can partially melt the indium bismuth tin alloy layer. Therefore, the indium bismuth tin alloy layer can meet requirements on both high thermal conductivity and a low melting point, and can be used as the second heat conduction layer of the heat conduction component.

In addition, the metal indium layer and the indium bismuth tin alloy layer have similarity in internal structures and are compatible. When the indium bismuth tin alloy layer melts into liquid, the liquid can be infiltrated into the metal indium layer, so as to prevent a molten liquid metal from flowing into the heat source component and affecting a normal operation of the heat source component.

In a possible implementation, the second heat conduction layer is elastic.

In an example, the heat sink is located on the heat conduction component, and the heat conduction component is located on the heat source component. The heat sink has a specific weight and may press the second heat conduction layer of the heat conduction component, the another second heat conduction layer of the heat conduction component presses the heat source component, and the second heat conduction layers are elastic. Therefore, the two second heat conduction layers of the heat conduction component may be in a compressed state, to improve the tight attachment between the heat sink and the second heat conduction layer and the tight attachment between the heat source component and the second heat conduction layer.

After the tight attachment between the heat conduction component and the heat source component is further improved, and after the tight attachment between the heat conduction component and the heat sink is further improved, a heat transfer effect between the heat source component, the heat conduction component, and the heat sink may be further enhanced.

In a possible implementation, a thickness of the first heat conduction layer is greater than a thickness of the second heat conduction layer.

In an example, the thickness of the first heat conduction layer may be greater than the thickness of the second heat conduction layer. The thickness of the first heat conduction layer is great, and the thickness of the second heat conduction layer is less than the thickness of the first heat conduction layer, so that an adsorption effect and an infiltration effect of the melted liquid of the second heat conduction layer on the first heat conduction layer can be improved, to prevent the liquid from flowing into the heat source component.

According to another aspect, a board is provided. The board includes a heat source component, a heat sink, and the foregoing heat conduction component. The heat conduction component is filled between the heat source component and the heat sink. A second heat conduction layer of the heat conduction component is tightly attached to the heat source component, and another second heat conduction layer of the heat conduction component is tightly attached to the heat sink.

In an example, the heat source component of the board may be a chip of the board, or may be a heat emitting component on the board, or the like. The heat conduction component may be placed on the heat source component, and the heat sink may be placed on the heat conduction component.

In this way, heat is generated by the heat source component during operation, and the second heat conduction layer in contact with the heat source component partially melts to generate liquid. Surface tension of the liquid is large, so that the liquid can be tightly attached to a surface of the heat source component. In this way, a gap between the heat conduction component and the heat source component is eliminated, and a heat transfer effect between the heat source component and the heat sink is enhanced. The second heat conduction layer in contact with the heat sink may also partially melt to generate liquid. Surface tension of the liquid is large, so that the liquid can be tightly attached to a surface of the heat sink. In this way, a gap between the heat conduction component and the heat sink is eliminated, and the heat transfer effect between the heat source component and the heat sink is enhanced.

In addition, because phase transition from solid to liquid occurs on the second heat conduction layer tightly attached to the heat source component, and a large amount of heat is absorbed in a phase transition process, heat is dissipated for the heat source component.

In addition, although the second heat conduction layer in the heat conduction component melts to generate liquid, because the first heat conduction layer and the second heat conduction layer are compatible, the liquid of the second heat conduction layer can be adsorbed and infiltrated into the first heat conduction layer, so as to prevent the liquid from flowing to the heat source component and causing damage to the heat source component.

According to another aspect, a computing device is provided. The computing device may include the foregoing board.

In some examples, the computing device may be a communication device, a multimedia device, an optical device, an electronic device, a terminal device, or the like, and may include the foregoing board.

According to another aspect, a heat conduction component manufacturing method is provided. A heat conduction component is the foregoing heat conduction component. The method includes: mounting a second heat conduction layer on a first surface of a first heat conduction layer; and mounting a second heat conduction layer on a second surface of the first heat conduction layer to obtain the heat conduction component. The first surface and the second surface are opposite to each other, a melting point of the first heat conduction layer is higher than a first value, a melting point of the second heat conduction layer is lower than a second value, the melting point of the first heat conduction layer is higher than the melting point of the second heat conduction layer, and the first value is greater than the second value.

In an example, the first heat conduction layer and second heat conduction layers may be first processed and manufactured, and then the heat conduction component is manufactured by using the first heat conduction layer and the second heat conduction layers. For example, the first heat conduction layer may be a metal indium layer. Metal indium may be processed to obtain a plate-like or sheet-like metal indium layer that is used as the first heat conduction layer. Undulated protrusion structures may be further arranged on the first heat conduction layer through processing. For example, the second heat conduction layer may be an indium bismuth tin alloy layer. An indium bismuth tin alloy may be processed to obtain a plate-like or sheet-like indium bismuth tin alloy layer that is used as the second heat conduction layer. Undulated protrusion structures may be further arranged on the second heat conduction layer through processing.

After the first heat conduction layer and the second heat conduction layer are obtained, the second heat conduction layer may be placed and fixed on the first surface of the first heat conduction layer, another second heat conduction layer may be placed and fixed on the second surface of the first heat conduction layer, and then the heat conduction component is obtained by performing curing processing and the like. Then, a cutting tool may be used to cut a heat conduction component with a large area to obtain a heat conduction component whose area matches an area of a heat source component.

The first heat conduction layer of the heat conduction component processed and manufactured in the foregoing method is sandwiched between the two second heat conduction layers, to form a contour shape of a sandwich structure. The heat conduction component of the sandwich structure may be filled between the heat source component and a heat sink. Because the melting point of the second heat conduction layer is low, heat generated by the heat source component during operation can partially melt the second heat conduction layer to generate liquid. The liquid is fluid and can fill a gap between the heat conduction component and the heat source component and a gap between the heat conduction component and the heat sink, so that tight attachment between the heat conduction component and the heat source component and tight attachment between the heat conduction component and the heat sink are improved, and a heat transfer effect of the heat between the heat source component and the heat sink is improved, to enhance heat dissipation for the heat source component.

Because the first heat conduction layer and the second heat conduction layer are compatible, the liquid generated by the second heat conduction layer can be adsorbed on the first heat conduction layer, so as to prevent the liquid from flowing to the heat source component and causing damage to the heat source component, so that the heat source component is further protected.

According to another aspect, a board manufacturing method is provided. The board is the foregoing board, and the method includes: mounting a heat conduction component on a heat source component; and mounting a heat sink on the heat conduction component, where a second heat conduction layer of the heat conduction component is tightly attached to the heat source component, and another second heat conduction layer of the heat conduction component is tightly attached to the heat sink.

A first heat conduction layer of the heat conduction component of the board manufactured in the foregoing method is sandwiched between two second heat conduction layers, to form a contour shape of a sandwich structure. The heat conduction component of the sandwich structure may be filled between the heat source component and the heat sink. Because a melting point of the second heat conduction layer is low, heat generated by the heat source component during operation can partially melt the second heat conduction layer to generate liquid. The liquid is fluid and can fill a gap between the heat conduction component and the heat source component and a gap between the heat conduction component and the heat sink, so that tight attachment between the heat conduction component and the heat source component and tight attachment between the heat conduction component and the heat sink are improved, and a heat transfer effect of the heat between the heat source component and the heat sink is improved, to enhance heat dissipation for the heat source component.

In some examples, the first heat conduction layer of the heat conduction component is sandwiched between the two second heat conduction layers, to form the contour shape of the sandwich structure. The heat conduction component of the sandwich structure may be filled between the heat source component and the heat sink. Because the melting point of the second heat conduction layer is low, the heat generated by the heat source component during operation can partially melt the second heat conduction layer to generate the liquid, and the liquid is fluid. Therefore, melted liquid of the second heat conduction layer that is tightly attached to the heat source component may fill the gap between the heat conduction component and the heat source component, and melted liquid of the second heat conduction layer that is tightly attached to the heat sink may fill the gap between the heat conduction component and the heat sink, so that the tight attachment between the heat conduction component and the heat source component and the tight attachment between the heat conduction component and the heat sink can be improved, thereby accelerating heat transfer between the heat source component and the heat sink, and enhancing heat dissipation for the heat source component.

### BRIEF DESCRIPTION OF DRAWINGS

FIG. 1 is a schematic diagram of a structure in which a heat conduction component is filled between a heat source component and a heat sink according to an embodiment of this application;
FIG. 2 is a schematic diagram of a structure in which a heat conduction component is filled between a heat source component and a heat sink according to an embodiment of this application;
FIG. 3 is a schematic diagram of a structure of a second heat conduction layer of a heat conduction component according to an embodiment of this application; and
FIG. 4 is a schematic diagram of a structure of a first heat conduction layer and second heat conduction layers of a heat conduction component according to an embodiment of this application.

### Reference numerals

1: Heat conduction component; 2: Chip; 3: Heat sink; 11: First heat conduction layer; 12: Second heat conduction layer.

### DESCRIPTION OF EMBODIMENTS

Embodiments of this application relate to a heat conduction component 1. The heat conduction component 1 may be used in fields such as a data communication device, a mobile phone, a notebook computer, an automobile, civil affairs, and lighting.

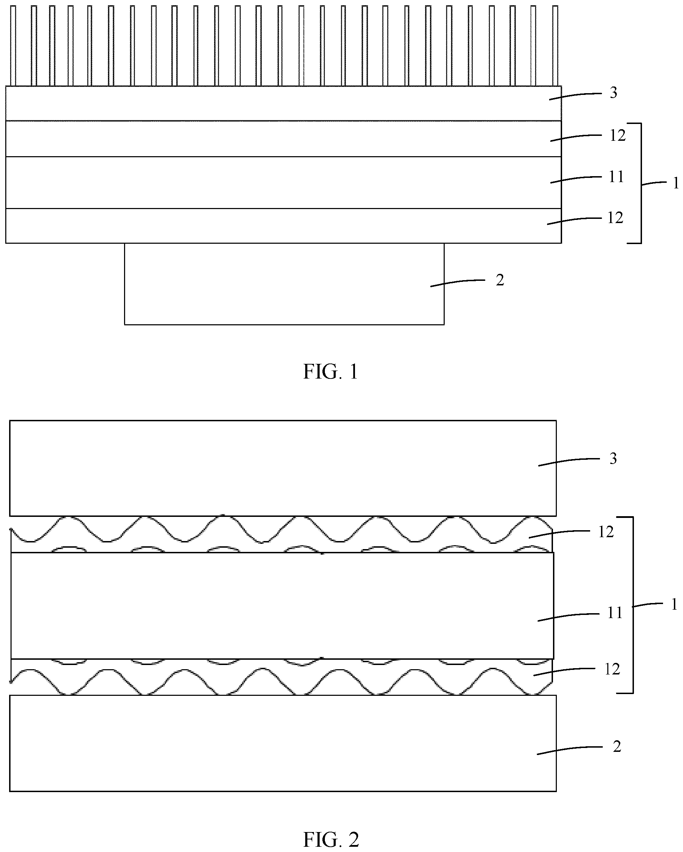

As shown in FIG. 1, the heat conduction component 1 is filled between a heat source component 2 and a heat sink 3, and is a thermal interface material (thermal interface material, TIM) used to absorb a gap between the heat source component 2 and the heat sink 3. As shown in FIG. 1, one surface of the heat conduction component 1 is tightly attached to the heat source component 2, and the other surface is tightly attached to the heat sink 3, so as to eliminate a gap between the heat conduction component 1 and the heat source component 2 and a gap between the heat conduction component 1 and the heat sink 3. In addition, the heat conduction component 1 is thermally conductive, and may transfer heat on the heat source component 2 to the heat sink 3, so that the heat generated by the heat source component 2 may be transferred to the heat sink 3 via the heat conduction component 1, and dissipated by the heat sink 3 to cool the heat source component 2.

The heat source component 2 may be a component that generates much heat during operation, for example, may be a chip, or may be one of various heat emitting components, for example, may be a resistor component.

The heat sink 3 may be a vapor chamber (vapor chamber, VC) heat sink, a water-cooled heat sink, or the like. A specific type of the heat sink is not limited in embodiments.

As shown in FIG. 1, the heat conduction component 1 includes a first heat conduction layer 11 and second heat conduction layers 12. A melting point of the first heat conduction layer 11 is greater than a first value, a melting point of the second heat conduction layer 12 is less than a second value, the first value is greater than the second value, there is the second heat conduction layer 12 on each of a first surface and a second surface of the first heat conduction layer 11, and the first surface and the second surface are opposite to each other.

Because the heat conduction component 1 is filled between the heat source component 2 and the heat sink 3, a size and a contour shape of the heat conduction component 1 are respectively related to a size and a contour shape of the heat source component 2.

For example, in terms of a size, an area of the heat conduction component 1 is adapted to an area of the heat source component 2. For example, the area of the heat conduction component 1 is equal to the area of the heat source component 2, or the area of the heat conduction component 1 is slightly greater than the area of the heat source component 2, so that the heat conduction component 1 can be in contact with all parts of the heat source component 2.

For example, in terms of a contour shape, the contour shape of the heat conduction component 1 is adapted to the contour shape of the heat source component 2. For example, if the contour shape of the heat source component 2 is a rectangle, the contour shape of the heat conduction component 1 may also be a rectangle.

In an example, the heat conduction component 1 includes the first heat conduction layer 11 and the second heat conduction layers 12. There may be one first heat conduction layer 11 and two second heat conduction layers 12, and the first heat conduction layer 11 is sandwiched between the two second heat conduction layers 12, to form a heat conduction component 1 of a sandwich structure. In an embodiment, as shown in FIG. 1, the heat conduction component 1 has a three-layer structure, an intermediate layer is the first heat conduction layer 11, and there is the second heat conduction layer 12 on each of the first surface and the second surface of the first heat conduction layer 11.

In another example, the heat conduction component 1 may include a plurality of the first heat conduction layers 11 and a plurality of the second heat conduction layers 12, the plurality of the first heat conduction layers 11 and the plurality of the second heat conduction layers 12 are stacked and fixed, and there is the second heat conduction layer 12 on each of a first surface and a second surface of each first heat conduction layer 11. For example, there may be two first heat conduction layers 11, and there may be three second heat conduction layers 12, the first heat conduction layers 11 and the second heat conduction layers 12 are alternately stacked, and there is the second heat conduction layer 12 on each of the first surface and the second surface that are of each first heat conduction layer 11 and that are opposite to each other, to form a heat conduction component 1 of a five-layer structure. One surface of the outermost two surfaces of the heat conduction component 1 is used for tightly attaching to the heat source component 2, and the other surface is used for tightly attaching to the heat sink 3. For another example, there may be three first heat conduction layers 11, and there may be four second heat conduction layers 12. Specific quantities of the first heat conduction layers 11 and the second heat conduction layers 12 are not limited in embodiments. A person skilled in the art may flexibly select a quantity based on an actual requirement. In the accompanying drawings, one first heat conduction layer 11 and two second heat conduction layers 12 may be used as an example.

In this way, when the heat conduction component 1 is filled between the heat source component 2 and the heat sink 3, the heat source component 2 is tightly attached to a second heat conduction layer 12 of the heat conduction component 1, and the heat sink 3 is tightly attached to another second heat conduction layer 12 of the heat conduction component 1.

In order to improve tight attachment between the heat source component 2 and the second heat conduction layer 12 and tight attachment between the heat sink 3 and the second heat conduction layer 12, the melting point of the second heat conduction layer 12 is low. For example, the melting point of the second heat conduction layer 12 is lower than the second value. A value of the second value is related to heat generated by the heat source component 2 during operation. For example, the second value may be obtained according to a principle that the heat generated by the heat source component 2 during operation can partially melt the second heat conduction layer 12, for example, may be within 100 degrees Celsius.

In this way, when the heat conduction component 1 is filled between the heat source component 2 and the heat sink 3, the heat source component 2 generates a large amount of heat during operation, and the second heat conduction layer 12 that is of the heat conduction component 1 and that is in contact with the heat source component 2 may partially melt to generate liquid. A surface area of the liquid is large, so that the liquid can be flatly spread on a surface that is of the heat source component 2 and that is in contact with the second heat conduction layer 12. Even if there is an original gap between the heat source component 2 and the second heat conduction layer 12 of the heat conduction component 1, after the second heat conduction layer 12 partially melts, the generated liquid can also fill the gap, to improve the tight attachment between the heat source component 2 and the second heat conduction layer 12 and accelerate heat transfer.

Similarly, the second heat conduction layer 12 that is of the heat conduction component 1 and that is in contact with the heat sink 3 may also partially melt to generate liquid due to the large amount of heat generated by the heat source component 2 during operation. A surface area of the liquid is large, so that the liquid can be flatly spread on a surface that is of the heat sink 3 and that is in contact with the second heat conduction layer 12. Even if there is an original gap between the heat sink 3 and the second heat conduction layer 12 of the heat conduction component 1, after the second heat conduction layer 12 partially melts, the generated liquid can also fill the gap, to improve the tight attachment between the heat sink 3 and the second heat conduction layer 12 and accelerate heat transfer.

The first heat conduction layer 11 and the second heat conduction layer 12 may be compatible, so that when the second heat conduction layer 12 melts into liquid, the liquid can be infiltrated into the first heat conduction layer 11.

In an example, to prevent damage to the heat source component 2 caused by the liquid flowing into the heat source component 2 after the second heat conduction layer 12 melts into the liquid, accordingly, the first heat conduction layer 11 may be a solid heat conduction layer with a high melting point. For example, the melting point of the first heat conduction layer 11 is higher than the first value, and a value of the first value is related to the heat generated by the heat source component 2 during operation. For example, the first value may be obtained according to a principle that the heat generated by the heat source component 2 during operation cannot melt the first heat conduction layer 11. For example, the first value may be 130 degrees Celsius.

In addition, a material for forming the first heat conduction layer 11 and a material for forming the second heat conduction layer 12 are similar in structure, to implement compatibility between the first heat conduction layer 11 and the second heat conduction layer 12. In this way, when the second heat conduction layer 12 melts and is converted into the liquid, the liquid may be infiltrated into the first heat conduction layer 11, so as to prevent the liquid of the second heat conduction layer 12 from flowing into the heat source component 2 or the heat sink 3.

Because the heat generated by the heat source component 2 during operation is limited, the second heat conduction layer 12 that is tightly attached to the heat source component 2 generally does not completely melt, but the second heat conduction layer 12 that is tightly attached to the heat source component 2 partially melts.

Based on the foregoing descriptions, in the heat conduction component 1 between the heat source component 2 and the heat sink 3, the second heat conduction layer 12 is tightly attached to the heat source component 2, and the another second heat conduction layer 12 is tightly attached to the heat sink 3. In this way, the heat is generated by the heat source component 2 during operation, and the second heat conduction layer 12 in contact with the heat source component 2 partially melts to generate the liquid. Surface tension of the liquid is large, so that the liquid can be tightly attached to the surface of the heat source component 2. In this way, the gap between the heat conduction component 1 and the heat source component 2 is eliminated, and a heat transfer effect between the heat source component 2 and the heat sink 3 is enhanced.

The second heat conduction layer 12 in contact with the heat sink 3 may also partially melt to generate the liquid. Surface tension of the liquid is large, so that the liquid can be tightly attached to the surface of the heat sink 3. In this way, the gap between the heat conduction component 1 and the heat sink 3 is eliminated, and the heat transfer effect between the heat source component 2 and the heat sink 3 is enhanced.

In addition, because phase transition from solid to liquid occurs on the second heat conduction layer 12 tightly attached to the heat source component 2, and a large amount of heat is absorbed in a phase transition process, heat is dissipated for the heat source component 2.

In some embodiments, the melting point of the first heat conduction layer 11 is higher than the melting point of the second heat conduction layer 12. For example, the melting point of the first heat conduction layer 11 is higher than 130 degrees Celsius, and the melting point of the second heat conduction layer 12 is within 100 degrees Celsius. The specific melting point of the first heat conduction layer 11 and the specific melting point of the second heat conduction layer 12 are both related to an operation temperature of the heat source component 2. For example, the melting point of the first heat conduction layer 11 is at least higher than a maximum temperature that the heat source component 2 can reach during operation. The specific melting point of the second heat conduction layer 12 is lower than the maximum temperature that the heat source component 2 can reach during operation, and is close to a temperature of the heat source component 2 during normal operation. For example, the specific melting point of the second heat conduction layer 12 is close to an average temperature of the heat source component 2 during operation.

In this way, during operation, the heat source component 2 generates the large amount of heat, and the temperature increases. The second heat conduction layer 12 that is tightly attached to the heat source component 2 melts to generate the liquid that is filled between the heat conduction component 1 and the heat source component 2, to absorb the gap and improve the heat transfer effect. In this case, the first heat conduction layer 11 is still in a solid state, and the first heat conduction layer 11 and the second heat conduction layer 12 are compatible. In this way, the melted liquid of the second heat conduction layer 12 can be infiltrated into the first heat conduction layer 11, to prevent the liquid from flowing out into the heat source component 2.

As shown in FIG. 2, there are protrusion structures on each of a first surface and a second surface of the second heat conduction layer 12, and the first surface and the second surface of the second heat conduction layer 12 are opposite to each other.

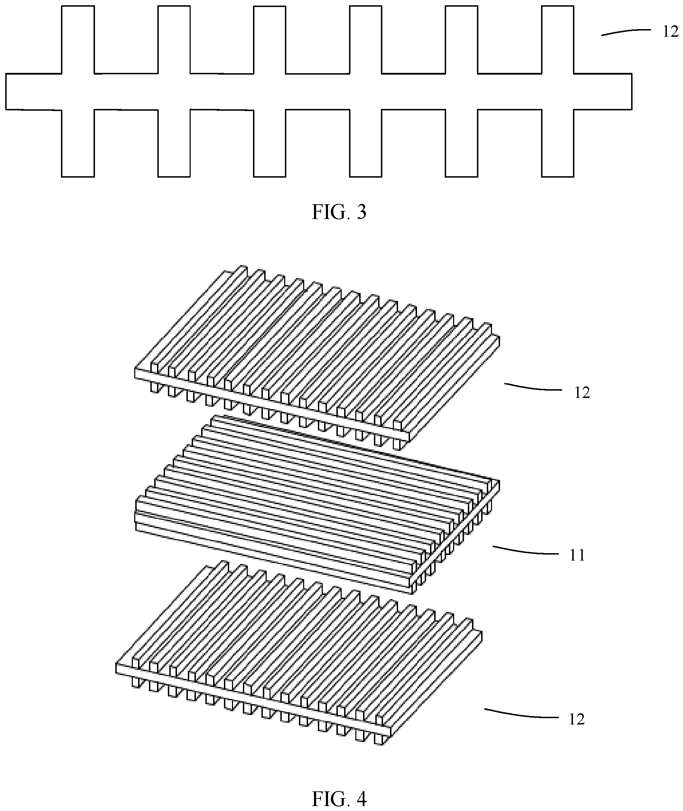

In some examples, the protrusion structure may also be referred to as an undulated structure. The protrusion structure may be a columnar protrusion, for example, a cylindrical protrusion. The protrusion structure may alternatively be a strip-shaped protrusion. For example, as shown in FIG. 3, there are periodically arranged strip-shaped protrusion structures on each of the first surface and the second surface of the second heat conduction layer 12. The protrusion structure may alternatively be a sawtooth-shaped protrusion. For example, as shown in FIG. 2, there are sawtooth-shaped protrusions on each of the first surface and the second surface of the second heat conduction layer 12.

As shown in FIG. 3, the protrusion structures may be periodically arranged on the first surface and the second surface of the second heat conduction layer 12, and the protrusion structures may be arranged at an equal spacing. For example, a spacing between two adjacent protrusion structures may be 200 micrometers. Sizes of the protrusion structures may be equal or may not be equal, and a skilled person may flexibly set the sizes based on an actual situation. For example, the protrusion structure is cylindrical, and a diameter of the protrusion structure may be 100 micrometers. For another example, the protrusion structure is a square column, and a side length of a cross section of the protrusion structure may be 100 micrometers.

A person skilled in the art may flexibly select sizes of the protrusion structures on the two surfaces of the second heat conduction layer 12, an arrangement of the protrusion structures, and the like based on an actual situation. This is not limited in embodiments.

The protrusion structures on the first surface and the second surface of the second heat conduction layer 12 are submillimeter-level or micrometer-level structures, and may be used to absorb mounting tolerances and mounting gaps, so as to improve tight attachment of the surfaces.

In an example, there are protrusion structures on the first surface and the second surface of the second heat conduction layer 12, and the undulated protrusion structures are fine, soft, and elastic. When the heat conduction component 1 is filled between the heat source component 2 and the heat sink 3, the protrusion structures on the two surfaces of the second heat conduction layer 12 can be compressed and deformed under pressure, to ensure that all parts of the second heat conduction layer 12 are in a compressed state. Therefore, tight attachment between the first heat conduction layer 11 and the second heat conduction layers 12, the tight attachment between the heat source component 2 and a second heat conduction layer 12 of the heat conduction component 1, and the tight attachment between the heat sink 3 and the another second heat conduction layer 12 of the heat conduction component 1 can be improved.

Once the tight attachment between the first heat conduction layer 11 and the second heat conduction layers 12 inside the heat conduction component 1, tight attachment between the heat source component 2 and the heat conduction component 1, and tight attachment between the heat sink 3 and the heat conduction component 1 are improved, heat in the heat source component 2 can be quickly transferred to the heat sink 3 via the heat conduction component 1, and the heat sink 3 dissipates the heat outward to accelerate heat dissipation for the heat source component 2.

Similarly, as shown in FIG. 4, there may also be protrusion structures on each of the first surface and the second surface of the first heat conduction layer 11.

In an example, there are the protrusion structures on each of the two surfaces that are of the first heat conduction layer 11 and that are opposite to each other, and the undulated protrusion structures are small, soft, and elastic. When the first heat conduction layer 11 is sandwiched between the two second heat conduction layers 12, both the protrusion structures on the first heat conduction layer 11 and protrusion structures on the second heat conduction layers 12 can be compressed and deformed under pressure. In this way, the tight attachment between the first heat conduction layer 11 and the second heat conduction layers 12 is improved, seamless contact inside the heat conduction component 1 is implemented, and quick transfer of heat inside the heat conduction component 1 is accelerated.

When there are the protrusion structures on each of the first heat conduction layer 11 and the second heat conduction layer 12, in a process of mounting the second heat conduction layers 12 on the two surfaces of the first heat conduction layer 11, as shown in FIG. 4, strip-shaped protrusion structures on the first heat conduction layer 11 may be perpendicular to strip-shaped protrusion structures on the second heat conduction layer 12. Certainly, alternatively, strip-shaped protrusion structures on the first heat conduction layer 11 and strip-shaped protrusion structures on the second heat conduction layer 12 may be parallel to each other and placed in a staggered manner. For example, the protrusion structure on the first heat conduction layer 11 is located between two adjacent protrusion structures on the second heat conduction layer 12. A specific location relationship between the protrusion structures on the first heat conduction layer 11 and the protrusion structures on the second heat conduction layer 12 is not limited in embodiments, and a person skilled in the art may flexibly select a location relationship based on an actual situation.

Based on the foregoing descriptions, when the heat conduction component 1 is filled between the heat source component 2 and the heat sink 3, inside the heat conduction component 1, there are undulated protrusion structures on each of surfaces that are of the first heat conduction layer 11 and the second heat conduction layer 12 and that are in contact with each other. These protrusion structures are compressed and deformed under pressure, so that a gap inside the heat conduction component 1 can be absorbed, and the gap inside the heat conduction component 1 can be reduced. In addition, the melting point of the second heat conduction layer 12 is low, and it is easy for the second heat conduction layer 12 to partially melt to generate liquid. The liquid may further fill the gap inside the heat conduction component 1, to reduce the gap inside the heat conduction component 1.

Between the heat conduction component 1 and the heat source component 2, there are undulated protrusion structures on the second heat conduction layer 12 that is of the heat conduction component 1 and that is tightly attached to the heat source component 2. The undulated protrusion structures are deformed and compressed under pressure of the heat conduction component 1, so that the gap between the heat conduction component 1 and the heat source component 2 can be absorbed, and the gap between the heat conduction component 1 and the heat source component 2 can be reduced. In addition, the melting point of the second heat conduction layer 12 is low, and it is easy for the second heat conduction layer 12 to partially melt to generate the liquid. The liquid may further fill the gap between the heat conduction component 1 and the heat source component 2, to reduce the gap between the heat conduction component 1 and the heat source component 2.

Between the heat conduction component 1 and the heat sink 3, there are undulated protrusion structures on the second heat conduction layer 12 that is of the heat conduction component 1 and that is tightly attached to the heat sink 3. The undulated protrusion structures are deformed and compressed under pressure of the heat sink 3, so that the gap between the heat conduction component 1 and the heat sink 3 can be absorbed, and the gap between the heat conduction component 1 and the heat sink 3 can be reduced. In addition, the melting point of the second heat conduction layer 12 is low, and it is easy for the second heat conduction layer 12 to partially melt to generate the liquid. The liquid may further fill the gap between the heat conduction component 1 and the heat sink 3, to reduce the gap between the heat conduction component 1 and the heat sink 3.

When the heat conduction component 1 is filled between the heat source component 2 and the heat sink 3, there are few gaps inside the heat conduction component 1, there are few gaps between the heat conduction component 1 and the heat source component 2, and there are also few gaps between the heat conduction component 1 and the heat sink 3. In this way, heat may be quickly transferred from the heat source component 2 to the heat sink 3 via the heat conduction component 1, and dissipated by the heat sink 3 outward. In this way, the heat conduction component 1 can greatly enhance the heat transfer effect between the heat source component 2 and the heat sink 3.

In addition, because the first heat conduction layer 11 and the second heat conduction layer 12 are compatible, the second heat conduction layer 12 melts to generate the liquid, and the liquid can be infiltrated into the first heat conduction layer 11, so as to prevent the randomly flowing liquid of the second heat conduction layer 12 from flowing to the heat source component 2, thereby protecting the heat source component 2.

To further absorb the gap between the heat source component 2 and the second heat conduction layer 12 and the gap between the heat sink 3 and the second heat conduction layer 12, the second heat conduction layer 12 may be elastic accordingly. In an example, the heat sink 3 is located on the heat conduction component 1, and the heat conduction component 1 is located on the heat source component 2. The heat sink 3 has a specific weight and may press the second heat conduction layer 12 of the heat conduction component 1, the another second heat conduction layer 12 of the heat conduction component 1 presses the heat source component 2, and the second heat conduction layers 12 are elastic. Therefore, the two second heat conduction layers 12 of the heat conduction component 1 may be in a compressed state, to improve the tight attachment between the heat sink 3 and the second heat conduction layer 12 and the tight attachment between the heat source component 2 and the second heat conduction layer 12.

After the tight attachment between the heat conduction component 1 and the heat source component 2 is further improved, and after the tight attachment between the heat conduction component 1 and the heat sink 3 is further improved, a heat transfer effect between the heat source component 1, the heat conduction component 2, and the heat sink 3 may be further enhanced.

In this way, because there are the undulated protrusion structures on each of the first heat conduction layer 11 and the second heat conduction layer 12 of the heat conduction component 1, and both the first heat conduction layer 11 and the second heat conduction layer 12 are elastic, when the heat conduction component 1 is located between the heat source component 2 and the heat sink 3, the protrusion structures on each of the first heat conduction layer 11 and the second heat conduction layer 12 of the heat conduction component 1 are compressed and deformed under pressure, so that close and tight attachment inside the heat conduction component 1, close and tight attachment between the heat conduction component 1 and the heat source component 2, and close and tight attachment between the heat conduction component 1 and the heat sink 3 can be improved.

In addition, because the melting point of the second heat conduction layer 12 of the heat conduction component 1 is low, when a temperature of the heat generated by the heat source component 2 rises to the melting point of the second heat conduction layer 12, the second heat conduction layer 12 in contact with the heat source component 2 may melt to generate the liquid. The liquid is fluid, and may further fill the gap between the heat source component 2 and the second heat conduction layer 12 of the heat conduction component 1, to further improve the close and tight attachment between the heat source component 2 and the heat conduction component 1. In addition, the second heat conduction layer 12 in contact with the heat sink 3 may also melt to generate the liquid. The liquid is fluid, and may fill the gap between the heat sink 3 and the second heat conduction layer 12 of the heat conduction component 1, to further improve the close and tight attachment between the heat sink 3 and the heat conduction component 1.

It can be learned that, in a case in which the close and tight attachment inside the heat conduction component 1 is implemented, the heat conduction component 1 is closely and tightly attached to the heat source component 2, and the heat conduction component 1 is closely and tightly attached to the heat sink 3, the heat transfer effect between the heat source component 2, the heat conduction component 1, and the heat sink 3 can be greatly improved.

In addition, because the melting point of the first heat conduction layer 11 is high, the first heat conduction layer 11 may always be in a solid state. The first heat conduction layer 11 and the second heat conduction layer 12 are compatible. Therefore, even if the second heat conduction layer 12 melts to generate the liquid, the liquid is only infiltrated into the first heat conduction layer 11, and it is difficult for the liquid to flow to the heat source component 2. In this way, a thickness of the second heat conduction layer 12 in the heat conduction component 1 may be greater.

The thickness of the second heat conduction layer 12 is increased, so that a filling effect of the liquid, in the gap, generated by melting the second heat conduction layer 12 can be further improved. A skilled person may set the thickness of the second heat conduction layer 12 based on an actual situation. For example, the second heat conduction layer 12 may be processed as thick as possible on a premise that the second heat conduction layer 12 melts to generate liquid and the liquid does not flow to the heat source component 2.

In an example, the thickness of the first heat conduction layer 11 may be greater than the thickness of the second heat conduction layer 12. The thickness of the first heat conduction layer 11 is great, and the thickness of the second heat conduction layer 12 is less than the thickness of the first heat conduction layer 11, so that an adsorption effect and an infiltration effect of the melted liquid of the second heat conduction layer 12 on the first heat conduction layer 11 can be improved, to prevent the liquid from flowing into the heat source component 2.

The foregoing is an example of improving the heat transfer effect in terms of the tight attachment inside the heat conduction component 1, the tight attachment between the heat conduction component 1 and the heat source component 2, and the tight attachment between the heat conduction component 1 and the heat sink 3. The heat transfer effect may be alternatively improved in another manner. For example, materials with high thermal conductivity may be used to improve the heat transfer effect.

Correspondingly, the first heat conduction layer 11 and the second heat conduction layer 12 of the heat conduction component 1 may be made of materials with high thermal conductivity. For example, both the first heat conduction layer 11 and the second heat conduction layer 12 may be metal layers.

In an example, the first heat conduction layer 11 may be a metal indium layer, and the second heat conduction layer 12 may be an indium bismuth tin alloy layer. A melting point of the metal indium layer is about 157 degrees Celsius, and an operating temperature of the heat source component 2 generally does not exceed 100 degrees Celsius. Therefore, the metal indium layer can meet requirements on both high thermal conductivity and a high melting point, and can be used as the first heat conduction layer 11 of the heat conduction component 1. A melting point of the indium bismuth tin alloy layer is between 58 degrees Celsius and 60 degrees Celsius, and the heat generated by the heat source component 2 can partially melt the indium bismuth tin alloy layer. Therefore, the indium bismuth tin alloy layer can meet requirements on both high thermal conductivity and a low melting point, and can be used as the second heat conduction layer 12 of the heat conduction component 1.

In addition, the metal indium layer and the indium bismuth tin alloy layer have similarity in internal structures and are compatible. When the indium bismuth tin alloy layer melts into liquid, the liquid can be infiltrated into the metal indium layer, so as to prevent a molten liquid metal from flowing into the heat source component 2 and affecting a normal operation of the heat source component 2.

In addition, both the first heat conduction layer 11 and the second heat conduction layer 12 are metal layers, and a metal is extensible, so that the first heat conduction layer 11 and the second heat conduction layer 12 can be elastic. Correspondingly, the protrusion structures on the first heat conduction layer 11 and the second heat conduction layer 12 are also elastic, and may be compressed and deformed under pressure, to enhance the tight attachment between the first heat conduction layer 11 and the second heat conduction layers 12, and absorb a mounting tolerance and a gap between the first heat conduction layer 11 and the second heat conduction layer 12. Further, the tight attachment between the heat conduction component 1 and the heat source component 2 may be enhanced, and a mounting tolerance and a gap between the heat conduction component 1 and the heat source component 2 may be absorbed. Further, the tight attachment between the heat conduction component 1 and the heat sink 3 may be enhanced, and a mounting tolerance and a gap between the heat conduction component 1 and the heat sink 3 may be absorbed.

When processing the indium bismuth tin alloy layer that is used as the second heat conduction layer 12, a skilled person may adjust contents of indium, bismuth, and tin based on an indicator that needs to be met, where the indicator that needs to be met may be a low melting point, high thermal conductivity, a low thermal resistance, or the like. For example, a possible mass percentage may be shown in the following Table 1.

**Table 1 Possible mass percentage of the indium bismuth tin alloy layer that is used as the second heat conduction layer**

| Element | Indium (In) | Bismuth (Bi) | Tin (Sn) |
|---|---|---|---|
| Mass percentage | 51% | 16.5% | 31.5% |

For example, during processing of the heat conduction component 1, metal indium may be compressed into a sheet-like structure with a thickness of about 100 to 150 micrometers, and an indium bismuth tin alloy is prepared into a sheet-like structure with a thickness of 25 to 30 micrometers. Afterwards, the protrusion structures may be arranged on two opposite surfaces of the sheet-like metal indium through pressing by using a tool such as a special-purpose roller, to obtain the first heat conduction layer 11, and the protrusion structures are arranged on two opposite surfaces of the sheet-like indium bismuth tin alloy through pressing, to obtain the second heat conduction layer 12. Then, one second heat conduction layer 12 may be mounted on the first surface of the first heat conduction layer 11, and one second heat conduction layer 12 may be mounted on the second surface of the first heat conduction layer 11, to obtain the heat conduction component 1 of a sandwich structure. Then, a technician may cut the heat conduction component 1 based on the size and a contour of the heat source component 2, to obtain a plurality of heat conduction components 1 that match the size and the contour of the heat source component 2.

After the heat conduction components 1 are obtained, to ensure that functions of the heat conduction component 1 are good, a thermal resistance effect test may be performed on the heat conduction components 1. For example, the thermal resistance effect test may be performed on the heat conduction components 1 by using a thermally conductive silica gel or a thermal resistance meter.

In some examples, the first heat conduction layer of the heat conduction component is sandwiched between the two second heat conduction layers, to form a contour shape of the sandwich structure. The heat conduction component of the sandwich structure may be filled between the heat source component and the heat sink. Because the melting point of the second heat conduction layer is low, the heat generated by the heat source component during operation can partially melt the second heat conduction layer to generate the liquid, and the liquid is fluid. Therefore, the melted liquid of the second heat conduction layer that is tightly attached to the heat source component may fill the gap between the heat conduction component and the heat source component, and the melted liquid of the second heat conduction layer that is tightly attached to the heat sink may fill the gap between the heat conduction component and the heat sink, so that the tight attachment between the heat conduction component and the heat source component and the tight attachment between the heat conduction component and the heat sink can be improved, thereby accelerating heat transfer between the heat source component and the heat sink, and enhancing heat dissipation for the heat source component.

Because the first heat conduction layer and the second heat conduction layer are compatible, the liquid generated by the second heat conduction layer can be adsorbed on the first heat conduction layer, so as to prevent the liquid from flowing to the heat source component and causing damage to the heat source component, so that the heat source component is further protected.

This application further provides a board. The board may be a main control board, a service board, an interface board, or the like of a computing device. As shown in FIG. 1, the board may include a heat source component 2, a heat sink 3, and the foregoing heat conduction component 1. The heat conduction component 1 is filled between the heat source component 2 and the heat sink 3. A second heat conduction layer 12 of the heat conduction component 1 is tightly attached to the heat source component 2, and another second heat conduction layer 12 of the heat conduction component 1 is tightly attached to the heat sink 3. In an embodiment, the second heat conduction layer 12 on a first surface of a first heat conduction layer 11 is tightly attached to the heat source component 2, and the second heat conduction layer 12 on a second surface of the first heat conduction layer 11 is tightly attached to the heat sink 3.

In an example, the heat source component 2 of the board may be a chip of the board, or may be a heat emitting component on the board, or the like. The heat conduction component 1 may be placed on the heat source component 2, and the heat sink 3 may be placed on the heat conduction component 1.

In this way, the heat is generated by the heat source component 2 during operation, and the second heat conduction layer 12 in contact with the heat source component 2 partially melts to generate liquid. Surface tension of the liquid is large, so that the liquid can be tightly attached to a surface of the heat source component 2. In this way, a gap between the heat conduction component 1 and the heat source component 2 is eliminated, and a heat transfer effect between the heat source component 2 and the heat sink 3 is enhanced. The second heat conduction layer 12 in contact with the heat sink 3 may also partially melt to generate liquid. Surface tension of the liquid is large, so that the liquid can be tightly attached to a surface of the heat sink 3. In this way, a gap between the heat conduction component 1 and the heat sink 3 is eliminated, and a heat transfer effect between the heat source component 2 and the heat sink 3 is enhanced.

In addition, because phase transition from solid to liquid occurs on the second heat conduction layer 12 tightly attached to the heat source component 2, and a large amount of heat is absorbed in a phase transition process, heat is dissipated for the heat source component 2.

In addition, although the second heat conduction layer 12 in the heat conduction component 1 melts to generate the liquid, because the first heat conduction layer 11 and the second heat conduction layer 12 are compatible, the liquid of the second heat conduction layer 12 can be adsorbed and infiltrated into the first heat conduction layer 11, so as to prevent the liquid from flowing to the heat source component 2 and causing damage to the heat source component 2.

In an example, the board may further include a circuit board, and the heat source component 2 may be mounted on the circuit board. For example, the heat source component 2 may be welded on the circuit board via a solder ball, then the heat conduction component 1 is placed on the heat source component 2, and the heat sink 3 is placed on the heat conduction component 1.

In another example, to bear a weight of the heat sink 3 and prevent the heat sink 3 from crushing the heat source component 2, accordingly, the board may further include a base, the circuit board may be placed and fixed on the base, the heat source component 2 may be welded on the circuit board via a solder ball, and the heat conduction component 1 may be placed on the heat source component 2. The heat sink 3 is placed on the heat conduction component 1, and the heat sink 3 is fixed on the base via a set screw. In this way, the weight of the heat sink 3 may be transferred to the base via the set screw, and the base bears the weight of the heat sink 3, so as to protect the heat source component and the circuit board.

In some examples, the heat source component 2 of the board generates the heat during operation, and the second heat conduction layer 12 in contact with the heat source component 2 partially melts to generate the liquid. Surface tension of the liquid is large, so that the liquid can be tightly attached to the surface of the heat source component 2. In this way, the gap between the heat conduction component 1 and the heat source component 2 is eliminated, and the heat transfer effect between the heat source component 2 and the heat sink 3 is enhanced. The second heat conduction layer 12 in contact with the heat sink 3 may also partially melt to generate the liquid. Surface tension of the liquid is large, so that the liquid can be tightly attached to the surface of the heat sink 3. In this way, the gap between the heat conduction component 1 and the heat sink 3 is eliminated, and the heat transfer effect between the heat source component 2 and the heat sink 3 is enhanced.

In addition, although the second heat conduction layer 12 in the heat conduction component 1 melts to generate the liquid, because the first heat conduction layer 11 and the second heat conduction layer 12 are compatible, the liquid of the second heat conduction layer 12 can be adsorbed and infiltrated into the first heat conduction layer 11, so as to prevent the liquid from flowing to the heat source component 2 and causing damage to the heat source component 2.

This application further provides a computing device. The computing device may include the foregoing board, and the computing device may be a computer device, a communication device, an optical device, an electronic device, a terminal device, or the like.

In some examples, a heat source component 2 of the board of the computing device generates heat during operation, and a second heat conduction layer 12 in contact with the heat source component 2 partially melts to generate liquid. Surface tension of the liquid is large, so that the liquid can be tightly attached to a surface of the heat source component 2. In this way, a gap between a heat conduction component 1 and the heat source component 2 is eliminated, and a heat transfer effect between the heat source component 2 and a heat sink 3 is enhanced. A second heat conduction layer 12 in contact with the heat sink 3 may also partially melt to generate liquid. Surface tension of the liquid is large, so that the liquid can be tightly attached to a surface of the heat sink 3. In this way, a gap between the heat conduction component 1 and the heat sink 3 is eliminated, and the heat transfer effect between the heat source component 2 and the heat sink 3 is enhanced.

This application further provides a heat conduction component manufacturing method. A heat conduction component is the foregoing heat conduction component. A process of manufacturing the heat conduction component may be as follows.

First, a second heat conduction layer 12 is placed on a first surface of a first heat conduction layer 11, and then the second heat conduction layer 12 is placed on a second surface of the first heat conduction layer 11, where the first surface and the second surface are opposite to each other, the second heat conduction layer 12 on the first surface is configured to tightly attach to a heat source component 2, and the second heat conduction layer 12 on the second surface is configured to tightly attach to a heat sink 3.

In an example, the first heat conduction layer 11 and the second heat conduction layers 12 may be first processed and manufactured, and then a heat conduction component 1 is manufactured by using the first heat conduction layer 11 and the second heat conduction layers 12. For example, the first heat conduction layer 11 may be a metal indium layer. Metal indium may be processed to obtain a plate-like or sheet-like metal indium layer that is used as the first heat conduction layer 11. Undulated protrusion structures may be further arranged on the first heat conduction layer 11 through processing. For example, the second heat conduction layer 12 may be an indium bismuth tin alloy layer. An indium bismuth tin alloy may be processed to obtain a plate-like or sheet-like indium bismuth tin alloy layer that is used as the second heat conduction layer 12. Undulated protrusion structures may be further arranged on the second heat conduction layer 12 through processing.

After the first heat conduction layer 11 and the second heat conduction layer 12 are obtained, the second heat conduction layer 12 may be placed and fixed on the first surface of the first heat conduction layer 11, another second heat conduction layer 12 may be placed and fixed on the second surface of the first heat conduction layer 11, and then the heat conduction component 1 is obtained by performing curing processing and the like. Then, a cutting tool may be used to cut the heat conduction component 1 with a large area to obtain a heat conduction component 1 whose area matches an area of the heat source component 2.

The first heat conduction layer of the heat conduction component processed and manufactured in the foregoing method is sandwiched between the two second heat conduction layers, to form a contour shape of a sandwich structure. The heat conduction component of the sandwich structure may be filled between the heat source component and the heat sink. Because a melting point of the second heat conduction layer is low, heat generated by the heat source component during operation can partially melt the second heat conduction layer to generate liquid. The liquid is fluid and can fill a gap between the heat conduction component and the heat source component and a gap between the heat conduction component and the heat sink, so that tight attachment between the heat conduction component and the heat source component and tight attachment between the heat conduction component and the heat sink are improved, and a heat transfer effect of the heat between the heat source component and the heat sink is improved, to enhance heat dissipation for the heat source component.

Because the first heat conduction layer and the second heat conduction layer are compatible, the liquid generated by the second heat conduction layer can be adsorbed on the first heat conduction layer, so as to prevent the liquid from flowing to the heat source component and causing damage to the heat source component, so that the heat source component is further protected.

This application further provides a board manufacturing method. A board may be the foregoing board. A manufacturing process of the board may be as follows. First, a heat conduction component 1 may be mounted on a heat source component 2. For example, the heat conduction component 1 may be placed on the heat source component 2. For another example, the heat conduction component 1 may be placed and fixed on the heat source component 2. Then, a heat sink 3 may be mounted on the heat conduction component 1. For example, the heat sink 3 may be placed on the heat conduction component 1. A second heat conduction layer 12 of the heat conduction component 1 of a sandwich structure is tightly attached to the heat source component 2, and another second heat conduction layer 12 is tightly attached to the heat sink 3. In an embodiment, the second heat conduction layer 12 on a first surface of a first heat conduction layer 11 of the heat conduction component 1 of the sandwich structure is tightly attached to the heat source component 2, and the second heat conduction layer 12 on a second surface of the first heat conduction layer 11 is tightly attached to the heat sink 3.

In some examples, the board may further include a circuit board and a base. Correspondingly, the method may further include: mounting the heat source component 2 on the circuit board, for example, welding the heat source component 2 on the circuit board via a solder ball. The method further includes: mounting the circuit board on the base, for example, placing and fixing the circuit board on the base. To prevent the heat sink 3 from crushing the heat source component, accordingly, the heat sink 3 may be placed at a side that is of the heat conduction component 1 and that is away from the heat source component 2, and is fixed to the base via a set screw. In this way, a weight of the heat sink 3 may be transferred to the base via the set screw, and the base bears the weight of the heat sink 3, to reduce load on the heat source component 2.

The first heat conduction layer of the heat conduction component of the board manufactured in the foregoing method is sandwiched between the two second heat conduction layers, to form a contour shape of the sandwich structure. The heat conduction component of the sandwich structure may be filled between the heat source component and the heat sink. Because a melting point of the second heat conduction layer is low, heat generated by the heat source component during operation can partially melt the second heat conduction layer to generate liquid, and the liquid is fluid. Therefore, melted liquid of the second heat conduction layer that is tightly attached to the heat source component may fill a gap between the heat conduction component and the heat source component, and melted liquid of the second heat conduction layer that is tightly attached to the heat sink may fill a gap between the heat conduction component and the heat sink, so that tight attachment between the heat conduction component and the heat source component and tight attachment between the heat conduction component and the heat sink can be improved, thereby accelerating heat transfer between the heat source component and the heat sink, and enhancing heat dissipation for the heat source component.

## Claims

1. A heat conduction component (1), wherein the heat conduction component (1) comprises a first heat conduction layer (11) and second heat conduction layers (12), wherein
a melting point of the first heat conduction layer (11) is greater than a first value, a melting point of the second heat conduction layer (12) is less than a second value, there is the second heat conduction layer (12) on each of a first surface and a second surface of the first heat conduction layer (11), and the first surface and the second surface of the first heat conduction layer (11) are opposite to each other,
wherein there are protrusion structures on each of a first surface and a second surface of the second heat conduction layer (12), and the first surface and the second surface of the second heat conduction layer (12) are opposite to each other.

2. The heat conduction component (1) according to claim 1, wherein the first heat conduction layer (11) and the second heat conduction layer (12) are compatible, so that when the second heat conduction layer (12) melts into liquid, the liquid can be infiltrated into the first heat conduction layer (11).

3. The heat conduction component (1) according to claim 1 or 2, wherein there are protrusion structures on each of the first surface and the second surface of the first heat conduction layer (11).

4. The heat conduction component (1) according to any one of claims 1 to 4, wherein the protrusion structure is one of a columnar protrusion, a strip-shaped protrusion, and a sawtooth-shaped protrusion

5. The heat conduction component (1) according to any one of claims 1 to 4, wherein both the first heat conduction layer (11) and the second heat conduction layer (12) are metal layers.

6. The heat conduction component (1) according to any one of claims 1 to 5, wherein the first heat conduction layer (11) is a metal indium layer, and the second heat conduction layer (12) is an indium bismuth tin alloy layer

7. The heat conduction component (1) according to any one of claims 1 to 6, wherein the second heat conduction layer (12) is elastic.

8. The heat conduction component (1) according to any one of claims 1 to 7, wherein a thickness of the first heat conduction layer (11) is greater than a thickness of the second heat conduction layer (12).

9. The heat conduction component (1) according to any one of claims 1 to 8, wherein there are a plurality of the first heat conduction layers (11) or the second heat conduction layers (12); and
the first heat conduction layer (11) and the second heat conduction layer (12) are stacked and fixed.

10. Aboard, wherein the board comprises a heat source component (2), a heat sink (3), and the heat conduction component (1) according to any one of claims 1 to 10, the heat conduction component (1) is filled between the heat source component (2) and the heat sink (3), a second heat conduction layer (12) of the heat conduction component (1) is tightly attached to the heat source component (2), and another second heat conduction layer (12) of the heat conduction component (1) is tightly attached to the heat sink (3).

11. A computing device, comprising the board according to claim 10.

12. A heat conduction component manufacturing method, comprising:
mounting a second heat conduction layer (12) on a first surface of a first heat conduction layer (11), wherein a melting point of the first heat conduction layer (11) is higher than a first value, and a melting point of the second heat conduction layer (12) is lower than a second value; and
mounting a second heat conduction layer (12) on a second surface of the first heat conduction layer (11), wherein the first surface and the second surface of the first heat conduction layer (11) are opposite to each other,
wherein there are protrusion structures on each of a first surface and a second surface of the second heat conduction layer (12), and the first surface and the second surface of the second heat conduction layer (12) are opposite to each other.

## Patentansprüche

1. Wärmeleitelement (1), wobei das Wärmeleitelement (1) eine erste Wärmeleitschicht (11) und zweite Wärmeleitschichten (12) umfasst, wobei
ein Schmelzpunkt der ersten Wärmeleitschicht (11) größer ist als ein erster Wert, ein Schmelzpunkt der zweiten Wärmeleitschicht (12) kleiner ist als ein zweiter Wert, sich die zweite Wärmeleitschicht (12) jeweils auf einer ersten Oberfläche und einer zweiten Oberfläche der ersten Wärmeleitschicht (11) befindet und die erste Oberfläche und die zweite Oberfläche der ersten Wärmeleitschicht (11) einander gegenüberliegen,
wobei sich auf einer ersten Oberfläche und einer zweiten Oberfläche der zweiten Wärmeleitschicht (12) jeweils Vorsprungstrukturen befinden und die erste Oberfläche und die zweite Oberfläche der zweiten Wärmeleitschicht (12) einander gegenüberliegen.

2. Wärmeleitelement (1) nach Anspruch 1, wobei die erste Wärmeleitschicht (11) und die zweite Wärmeleitschicht (12) kompatibel sind, so dass, wenn die zweite Wärmeleitschicht (12) zu einer Flüssigkeit schmilzt, die Flüssigkeit in die erste Wärmeleitschicht (11) infilitriert werden kann.

3. Wärmeleitelement (1) nach Anspruch 1 oder 2, wobei sich auf der ersten Oberfläche und der zweiten Oberfläche der ersten Wärmeleitschicht (11) jeweils Vorsprungstrukturen befinden.

4. Wärmeleitelement (1) nach einem der Ansprüche 1 bis 4, wobei die Vorsprungstruktur ein säulenförmiger Vorsprung, ein streifenförmiger Vorsprung oder ein sägezahnförmiger Vorsprung ist.

5. Wärmeleitelement (1) nach einem der Ansprüche 1 bis 4, wobei sowohl die erste Wärmeleitschicht (11) als auch die zweite Wärmeleitschicht (12) Metallschichten sind.

6. Wärmeleitelement (1) nach einem der Ansprüche 1 bis 5, wobei die erste Wärmeleitschicht (11) eine Indium-Metallschicht ist und die zweite Wärmeleitschicht (12) eine Indium-Wismut-Zinn-Legierungsschicht ist.

7. Wärmeleitelement (1) nach einem der Ansprüche 1 bis 6, wobei die zweite Wärmeleitschicht (12) elastisch ist.

8. Wärmeleitelement (1) nach einem der Ansprüche 1 bis 7, wobei eine Dicke der ersten Wärmeleitschicht (11) größer ist als eine Dicke der zweiten Wärmeleitschicht (12).

9. Wärmeleitelement (1) nach einem der Ansprüche 1 bis 8, wobei eine Vielzahl von ersten Wärmeleitschichten (11) oder von zweiten Wärmeleitschichten (12) vorhanden ist; und
die erste Wärmeleitschicht (11) und die zweite Wärmeleitschicht (12) gestapelt und fixiert sind.

10. Einzelplatine, wobei die Platine ein Wärmequellelement (2), einen Kühlkörper (3) und das Wärmeleitelement (1) nach einem der Ansprüche 1 bis 10 umfasst, wobei das Wärmeleitelement (1) zwischen das Wärmequellelement (2) und den Kühlkörper (3) eingefüllt ist, eine zweite Wärmeleitschicht (12) des Wärmeleitelements (1) fest mit dem Wärmequellelement (2) verbunden ist und eine weitere zweite Wärmeleitschicht (12) des Wärmeleitelements (1) fest mit dem Kühlkörper (3) verbunden ist.

11. Computervorrichtung, die die Platine nach Anspruch 10 umfasst.

12. Verfahren zur Herstellung eines Wärmeleitelements, umfassend:
Anbringen einer zweiten Wärmeleitschicht (12) auf einer ersten Oberfläche einer ersten Wärmeleitschicht (11), wobei ein Schmelzpunkt der ersten Wärmeleitschicht (11) höher als ein erster Wert ist und ein Schmelzpunkt der zweiten Wärmeleitschicht (12) niedriger als ein zweiter Wert ist; und
Anbringen einer zweiten Wärmeleitschicht (12) auf einer zweiten Oberfläche der ersten Wärmeleitschicht (11), wobei die erste Oberfläche und die zweite Oberfläche der ersten Wärmeleitschicht (11) einander gegenüberliegen,
wobei sich auf einer ersten Oberfläche und einer zweiten Oberfläche der zweiten Wärmeleitschicht (12) jeweils Vorsprungstrukturen befinden und die erste Oberfläche und die zweite Oberfläche der zweiten Wärmeleitschicht (12) einander gegenüberliegen.

## Revendications

1. Composant conducteur thermique (1), dans lequel le composant conducteur thermique (1) comprend une première couche de conduction thermique (11) et des secondes couches de conduction thermiques (12), dans lequel
un point de fusion de la première couche de conduction thermique (11) est supérieur à une première valeur, un point de fusion de la seconde couche de conduction thermique (12) est inférieur à une seconde valeur, la seconde couche de conduction thermique (12) est présente sur chacune d'une première surface et d'une seconde surface de la première couche de conduction thermique (11), et la première surface et la seconde surface de la première couche de conduction thermique (11) sont opposées l'une à l'autre,
dans lequel des structures en saillie sont présentes sur chacune d'une première surface et d'une seconde surface de la seconde couche de conduction thermique (12), et la première surface et la seconde surface de la seconde couche de conduction thermique (12) sont opposées l'une à l'autre.

2. Composant conducteur thermique (1) selon la revendication 1, dans lequel la première couche de conduction thermique (11) et la seconde couche de conduction thermique (12) sont compatibles, de sorte que lorsque la seconde couche de conduction thermique (12) fond dans un liquide, le liquide peut être infiltré dans la première couche de conduction thermique (11).

3. Composant conducteur thermique (1) selon la revendication 1 ou 2, dans lequel des structures en saillie sont présentes sur chacune de la première surface et de la seconde surface de la première couche de conduction thermique (11).

4. Composant conducteur thermique (1) selon l'une quelconque des revendications 1 à 4, dans lequel la structure en saillie est l'une parmi une saillie en forme de colonne, une saillie en forme de bande et une saillie en forme de dents de scie.

5. Composant conducteur thermique (1) selon l'une quelconque des revendications 1 à 4, dans lequel la première couche de conduction thermique (11) et la seconde couche de conduction thermique (12) sont toutes deux des couches métalliques.

6. Composant conducteur thermique (1) selon l'une quelconque des revendications 1 à 5, dans lequel la première couche de conduction thermique (11) est une couche d'indium métallique, et la seconde couche de conduction thermique (12) est une couche d'alliage d'indium, de bismuth et d'étain.

7. Composant conducteur thermique (1) selon l'une quelconque des revendications 1 à 6, dans lequel la seconde couche de conduction thermique (12) est élastique.

8. Composant conducteur thermique (1) selon l'une quelconque des revendications 1 à 7, dans lequel une épaisseur de la première couche de conduction thermique (11) est supérieure à une épaisseur de la seconde couche de conduction thermique (12).

9. Composant conducteur thermique (1) selon l'une quelconque des revendications 1 à 8, dans lequel il y a une pluralité des premières couches de conduction thermique (11) ou des secondes couches de conduction thermique (12) ; et
la première couche de conduction thermique (11) et la seconde couche de conduction thermique (12) sont empilées et fixées.

10. Carte, dans laquelle la carte comprend un composant de source de chaleur (2), un dissipateur thermique (3) et le composant conducteur thermique (1) selon l'une quelconque des revendications 1 à 10, le composant conducteur thermique (1) est inséré entre le composant de source de chaleur (2) et le dissipateur thermique (3), une seconde couche de conduction thermique (12) du composant conducteur thermique (1) est étroitement fixée au composant de source de chaleur (2), et une autre seconde couche de conduction thermique (12) du composant conducteur thermique (1) est étroitement fixée au dissipateur thermique (3).

11. Dispositif informatique, comprenant la carte selon la revendication 10.

12. Procédé de fabrication de composant conducteur thermique, comprenant :
l'installation d'une seconde couche de conduction thermique (12) sur une première surface d'une première couche de conduction thermique (11), dans lequel le point de fusion de la première couche de conduction thermique (11) est supérieur à une première valeur, et un point de fusion de la seconde couche de conduction thermique (12) est inférieure à une seconde valeur ; et
l'installation d'une seconde couche de conduction thermique (12) sur une seconde surface de la première couche de conduction thermique (11), dans lequel la première surface et la seconde surface de la première couche de conduction thermique (11) sont opposées l'une à l'autre,
dans lequel des structures en saillie sont présentes sur chacune d'une première surface et d'une seconde surface de la seconde couche de conduction thermique (12), et la première surface et la seconde surface de la seconde couche de conduction thermique (12) sont opposées l'une à l'autre.
